(19) Europäisches Patentamt
European Patent Office
Office européen des brevets

(11) **EP 2 100 365 B1**

(12) **EUROPÄISCHE PATENTSCHRIFT**

(45) Veröffentlichungstag und Bekanntmachung des Hinweises auf die Patenterteilung:
**26.09.2018  Patentblatt 2018/39**

(21) Anmeldenummer: **06828681.4**

(22) Anmeldetag: **08.12.2006**

(51) Int Cl.:
**G01R 31/02** (2006.01)　　　**H02M 7/483** (2007.01)

(86) Internationale Anmeldenummer:
**PCT/DE2006/002250**

(87) Internationale Veröffentlichungsnummer:
**WO 2008/067787 (12.06.2008 Gazette 2008/24)**

(54) **ÜBERWACHUNG DER ALTERUNG DER KONDENSATOREN IN EINEM UMRICHTER MITTELS KAPAZITÄTSMESSUNG**

MONITORING OF THE AGING OF CAPACITORS IN A CONVERTER BY MEANS OF CAPACITANCE MEASUREMENT

SURVEILLANCE DU VIEILLISSEMENT DES CONDENSATEURS D'UN CONVERTISSEUR PAR MESURE DE LA CAPACITÉ

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**16.09.2009  Patentblatt 2009/38**

(73) Patentinhaber: **Siemens Aktiengesellschaft 80333 München (DE)**

(72) Erfinder:
• **DOMMASCHK, Mike 01945 Guteborn (DE)**
• **DORN, Jörg 96155 Buttenheim (DE)**
• **EULER, Ingo 91056 Erlangen (DE)**
• **LANG, Jörg 95346 Stadtsteinach (DE)**
• **TU, Quoc-Buu 90574 Rosstal (DE)**
• **WÜRFLINGER, Klaus 90419 Nürnberg (DE)**

(56) Entgegenhaltungen:
**DE-A1- 10 103 031　　DE-A1- 10 309 937**

EP 2 100 365 B1

**Beschreibung**

Die vorliegende Erfindung betrifft eine Vorrichtung zum Umrichten eines elektrischen Stromes mit wenigstens einem Phasenmodul, das einen Wechselspannungsanschluss und wenigstens einen Gleichspannungsanschluss aufweist, wobei zwischen jedem Gleichspannungsanschluss und dem Wechselspannungsanschluss ein Phasenmodulzweig ausgebildet ist und wobei jeder Phasenmodulzweig über eine Reihenschaltung aus Submodulen verfügt, die jeweils einen Kondensator und wenigstens einen Leistungshalbleiter aufweisen.

Die Erfindung betrifft ferner ein Verfahren zum Umrichten eines Stromes.

Eine solche Vorrichtung und ein solches Verfahren sind beispielsweise aus dem Beitrag von A. Lesnicar und R. Marquardt "An Innovative Modular Multilevel Converter Topology Suitable for a Wide Power Range", der auf der Powertech 2003 erschien, bereits bekannt. Dort ist ein Stromrichter offenbart, der für einen Anschluss an ein Wechselspannungsnetz vorgesehen ist.

Der Stromrichter weist für jede Phase des mit ihm zu verbindenden Wechselspannungsnetzes ein Phasenmodul auf, wobei jedes Phasenmodul über einen Wechselspannungsanschluss sowie zwei Gleichspannungsanschlüsse verfügt. Zwischen jedem Gleichspannungsanschluss und dem Wechselspannungsanschluss erstrecken sich Phasenmodulzweige, so dass eine so genannte 6-Puls-Brückenschaltung bereitgestellt ist. Die Modulzweige bestehen aus einer Reihenschaltung von Submodulen, die jeweils aus zwei abschaltbaren Leistungshalbleitern bestehen, denen jeweils gegensinnige Freilaufdioden parallel geschaltet sind. Die abschaltbaren Leistungshalbleiter und die Freilaufdioden sind in Reihe geschaltet, wobei parallel zur besagten Reihenschaltung ein Kondensator vorgesehen ist. Die besagten Komponenten der Submodule sind so miteinander verschaltet, dass am zweipoligen Ausgang jedes Submoduls entweder die Kondensatorspannung oder die Spannung null abfällt.

Die Steuerung der abschaltbaren Leistungshalbleiter erfolgt mittels der so genannten Pulsweitenmodulation. Die Regelungsmittel zur Steuerung der Leistungshalbleiter weisen Messsensoren zum Erfassen von Strömen unter Gewinnung von Stromwerten auf. Die Stromwerte werden einer zentralen Steuerungseinheit zugeführt, die eine Eingangsschnittstelle und eine Ausgangsschnittstelle aufweist. Zwischen der Eingangsschnittstelle und der Ausgangsschnittstelle ist ein Modulator, also eine Softwareroutine, vorgesehen. Der Modulator weist unter anderem eine Auswähleinheit sowie einen Pulsweitengenerator auf. Der Pulsweitengenerator erzeugt die Steuersignale für die einzelnen Submodule. Die abschaltbaren Leistungshalbleiter werden durch die vom Pulsweitengenerator erzeugten Steuersignale von einer Durchgangsstellung, in der ein Stromfluss über die abschaltbaren Leistungshalbleiter ermöglicht ist, in eine Sperrstellung überführt, in der ein Stromfluss über die abschaltbaren Leistungshalbleiter unterbrochen ist. Dabei weist jedes Submodul ein Submodulsensor zum Erfassen einer am Kondensator abfallenden Spannung auf.

Weitere Beiträge zum Steuerverfahren für eine so genannte Multi-Level-Stromrichtertopologie sind von R. Marquardt, A. Lesnicar, J. Hildinger, "Modulares Stromrichterkonzept für Netzkupplungsanwendung bei hohen Spannungen", erschienen auf der ETG-Fachtagung in Bad Nauenheim, Deutschland 2002, von A. Lesnicar, R. Marquardt, "A new modular voltage source inverter topology", EPE' 03 Toulouse, Frankreich 2003 und von R. Marquardt, A. Lesnicar "New Concept for High Voltage - Modular Multilevel Converter", PESC 2004 Conference in Aachen, Deutschland, bekannt.

Aus der derzeit noch unveröffentlichten deutschen Patentanmeldung 10 2005 045 090.3 ist ein Verfahren zur Steuerung eines mehrphasigen Stromrichters mit verteilten Energiespeichern offenbart. Die offenbarte Vorrichtung weist ebenfalls eine Multi-Level-Stromrichtertopologie mit Phasenmodulen auf, die über einen symmetrisch in der Mitte jedes Phasenmoduls angeordneten Wechselspannungsanschluss und zwei Gleichspannungsanschlüsse verfügen. Jedes Phasenmodul ist aus zwei Phasenmodulzweigen zusammengesetzt, die sich zwischen dem Wechselspannungsanschluss und einem der Gleichspannungsanschlüsse erstrecken. Jeder Phasenmodulzweig umfasst wiederum eine Reihenschaltung aus Submodulen, wobei jedes Submodul aus abschaltbaren Leistungshalbleitern und diesen antiparallel geschalteten Freilaufdioden besteht. Ferner verfügt jedes Submodul über einen unipolaren Kondensator. Zur Regelung der Leistungshalbleiter dienen Regelungsmittel, die auch zum Einstellen von Zweigströmen eingerichtet sind, welche zwischen den Phasenmodulen fließen. Durch die Steuerung der Zweigströme können beispielsweise Stromschwingungen aktiv gedämpft und Betriebspunkte mit kleineren Ausgangsfrequenzen vermieden werden. Darüber hinaus kann eine gleichmäßige Belastung aller abschaltbaren Halbleiterschalter sowie eine Symmetrierung von stark unsymmetrischen Spannungen herbeigeführt werden.

Energiespeicher, wie beispielsweise Kondensatoren im Zwischenkreis von Stromrichtermodulen besitzen die Eigenschaft, dass sie im Betrieb altern. Dabei verlieren Kondensatoren an Kapazität, wodurch bei einer bestimmten Spannung die von ihnen gespeicherte Ladung immer geringer wird. Bei der Wartung von Anlagen von Zwischenkreisstromrichtern wäre es vorteilhaft zu wissen, welche Kondensatoren soviel Kapazität verloren haben, dass ein Austausch erforderlich ist. Damit kann die Ausfallrate der Kondensatoren im Betrieb des Stromrichters gesenkt und die Verfügbarkeit erhöht werden. In Stromrichtertopologien mit großen gemeinsamen Zwischenkreiskondensatoren, wie beispielsweise in der Zwei-Punkt- oder Drei-Punkt-Technik, macht die Überwachung des Kapazitätsabbaus der Kondensatoren wenig Sinn, da die Veränderung nur einen Bruchteil der Gesamtkapazität betragen würde und daher messtechnisch kaum zu erfassen wäre. Ein solcher Kapazitätsabbau kann jedoch zum Ausfall des Stromrichters führen. Ein weiterer Nachteil der großen gemeinsamen Zwischenkreiskondensatoren ist, dass diese nur schwer oder gar nicht ausgetauscht oder ersetzt werden können.

Aus der Offenlegungsschrift DE 101 03 031 A1 ist eine Stromrichterschaltung mit verteilten Energiespeichern bekannt. Diese Stromrichterschaltung weist in einer elektrischen Reihenschaltung eine Vielzahl von gleichartigen Subsystemen auf. Die Subsysteme enthalten jeweils zwei Leistungshalbleiterschalter sowie einen Kondensator.

Die Offenlegungsschrift DE 103 09 937 A1 offenbart eine Diagnoseschaltung und ein Verfahren zur Prüfung eines in einem Kraftfahrzeug eingebauten Kondensators. Dazu ist der Kondensator mit einem Strommesser und einem Spannungsmesser ausgerüstet. Insbesondere durch Auswertung der aufgrund der Selbstentladung des Kondensators langsam absinkenden Kondensatorspannung werden Rückschlüsse auf den Zustand und die Alterung des Kondensators gezogen.

Aufgabe der Erfindung ist es, eine Vorrichtung und ein Verfahren der eingangs genannten Art bereitzustellen, mit denen eine Alterung der Kondensatoren auf einfache Weise feststellbar ist.

Diese Aufgabe wird durch eine Vorrichtung gemäß Anspruch 1 und durch ein Verfahren gemäß Anspruch 2 gelöst.

Die Erfindung löst diese Aufgabe durch Kondensatordiagnosemittel zum zeitabhängigen Bestimmen der Kapazität jedes Kondensators.

Erfindungsgemäß sind Kondensatordiagnosemittel bereitgestellt, die fortwährend die Kapazität der Kondensatoren der erfindungsgemäßen Vorrichtung bestimmen. Die erfindungsgemäße Vorrichtung weist verteilte Kondensatoren auf mit einer entsprechend kleineren Kapazität als Vorrichtungen mit einem zentralen Kondensator im Gleichspannungskreis. Es wurde erkannt, dass es nun möglich ist, die Änderung der Kapazität messtechnisch zu erfassen. Es ist im Rahmen der Erfindung weniger entscheidend zu wissen, welche Kapazität die einzelnen Kondensatoren genau besitzen. Vielmehr ist es wichtig in Erfahrung zu bringen, wie sich die Kapazitäten der einzelnen Kondensatoren über die Zeit hinweg ändern. Damit können Kondensatoren mit nachlassender Kapazität von fehlerfreien Kondensatoren unterschieden und erfasst werden. Erfindungsgemäß wird die jeweilige Kapazität der einzelnen Kondensatoren daher mittels der Kondensatordiagnosemittel in Abhängigkeit der Zeit ermittelt.

Zweckmäßigerweise umfassen die Kondensatordiagnosemittel für jedes Phasenmodul einen Zweigstromsensor zum Erfassen eines in dem zugeordneten Phasenmodul fließenden Phasenmodulzweigstromes und für jedes Submodul einen Submodulsensor zum Erfassen einer an dem Kondensator des zugeordneten Submoduls abfallenden Kondensatorspannung sowie Mittel zum Erfassen der Schaltzustände des jeweils zugeordneten Submoduls, wobei eine Auswerteeinheit die Kapazität der Kondensatoren jedes Phasenmoduls in Abhängigkeit des jeweils gemessenen Phasenmodulzweigstromes $I_{zwg}$, des oder der Schaltzustände und der jeweiligen Kondensatorspannung $U_c$ bestimmt. Durch diese in zeitliche Intervalle aufgeteilte Integration des erfassten Zweigstromes ergibt sich die Ladungsänderung $\Delta Q$ der Kondensatoren des überwachten Phasenmoduls. Die Submodulsensoren dienen zum Erfassen der an dem jeweiligen Kondensator abfallenden Spannung. Die Kapazität jedes Kondensators ergibt sich durch die Division der Ladungsänderung $\Delta Q$ durch die Spannungsänderung $\Delta U_c$, wobei jeweils zwischen dem Zu- und dem Abschaltzeitpunkt des Submoduls die Spannung und die Ladung erfasst werden. Ist das Submodul zugeschaltet fällt an den Ausgangsklemmen des Submoduls die Kondensatorspannung ab. Im abgeschalteten Zustand fällt an den Klemmen die Spannung null ab.

Die Erfindung löst diese Aufgabe ausgehend von dem eingangs genannten Verfahren mittels eines Umrichters, der wenigstens ein Phasenmodul mit wenigstens einem Gleichspannungsanschluss und einem Wechselspannungsanschluss aufweist, wobei zwischen jedem Gleichspannungsanschluss und dem Wechselspannungsanschluss ein Phasenmodulzweig ausgebildet ist, der über eine Reihenschaltung aus Submodulen verfügt, die jeweils einen Kondensator und wenigstens einen Leistungshalbleiter aufweisen, bei dem die Kapazität des Kondensators in Abhängigkeit der Zeit bestimmt wird.

Gemäß einer diesbezüglich zweckmäßigen Weiterentwicklung wird in Abhängigkeit der Zeit der Phasenmodulzweigstrom eines jeden Phasenmoduls unter Gewinnung von Phasenmodulzweigstromwerten erfasst, die an jedem Kondensator abfallende Kondensatorspannung unter Gewinnung von Kondensatorspannungswerten gemessen und schließlich eine Spannungsänderung ermittelt, der Phasenmodulzweigstrom zum Erhalt der Ladungsänderung zwischen dem Zu- und Abschalten der Leistungshalbleiter der Submodule integriert und die Änderung der Kapazität der Kondensatoren des jeweiligen Phasenmoduls aus der Ladungsänderung und aus der Spannungsänderung bestimmt. Unter Zu- und Abschalten der Leistungshalbleiter sind die Schaltzustände der Leistungshalbleiter zu verstehen, bei denen ein Stromfluss zum Kondensator in dem jeweiligen Submodul ermöglicht ist.

Weitere Ausgestaltungen und Vorteile der Erfindung sind Gegenstand der nachfolgenden Beschreibung von Ausführungsbeispielen der Erfindung mit Bezug auf die Figuren der Zeichnung, wobei gleiche Bezugszeichen auf gleich wirkende Bauteile verweisen und wobei

Figur 1   ein Ausführungsbeispiel der erfindungsgemäßen Vorrichtung und

Figur 2   ein Phasenmodul einer Vorrichtung gemäß Figur 1 zeigen.

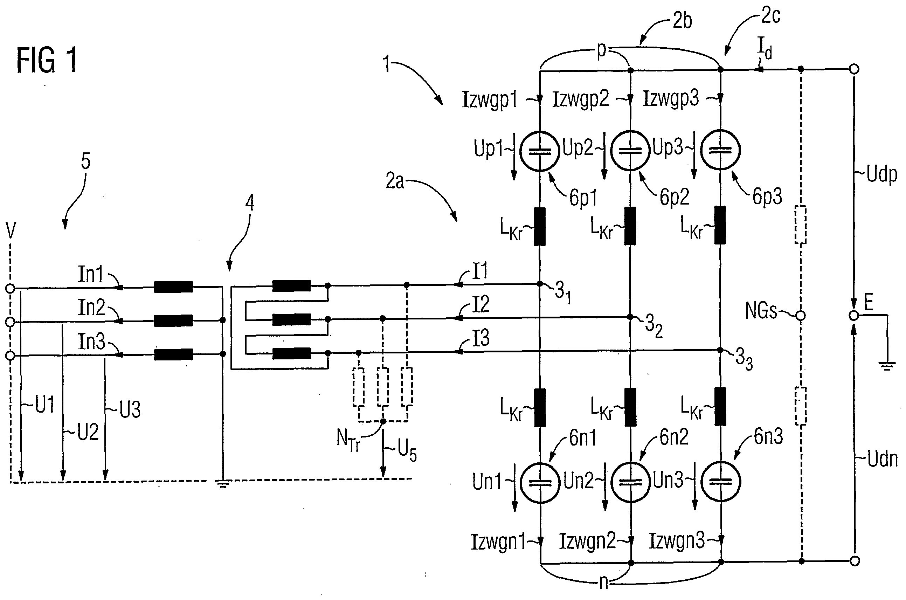

Figur 1 zeigt ein Ausführungsbeispiel der erfindungsgemäßen Vorrichtung 1, die aus drei Phasenmodulen 2a, 2b und 2c zusammengesetzt ist. Jedes Phasenmodul 2a, 2b und 2c ist mit einer positiven Gleichspannungsleitung p sowie mit einer negativen Gleichspannungsleitung n verbunden, so dass jedes Phasenmodul 2a,2b,2c zwei Gleichspannungsanschlüsse aufweist. Ferner ist für jedes Phasenmodul 2a, 2b und 2c jeweils ein Wechselspannungsanschluss $3_1$, $3_2$ und $3_3$ vorgesehen. Die Wechselspannungsanschlüsse $3_1$, $3_2$ und $3_3$ sind über einen Transformator 4 mit einem dreiphasigen Wechselspannungsnetz 5 verbunden. An den Phasen des Wechselspannungsnetzes 5 fallen die Phasenspannungen U1, U2 und U3 ab, wobei Netzströme In1, In2 und In3 fließen. Der wechselspannungsseitige Phasenstrom eines jeden Phasenmoduls wird mit I1, I2 und I3 bezeichnet. Der Gleichspannungsstrom ist $I_d$. Zwischen jedem der Wechselspannungsanschlüsse $3_1$, $3_2$ oder $3_3$ und der positiven Gleichspannungsleitung p erstrecken sich Phasenmodulzweige 6p1, 6p2 und 6p3. Zwischen jedem Wechselspannungsanschluss $3_1$, $3_2$, $3_3$ und der negativen Gleichspannungsleitung n sind die Phasenmodulzweige 6n1, 6n2 und 6n3 ausgebildet. Jeder Phasenmodulzweig 6p1, 6p2, 6p3, 6n1, 6n2 und 6n3 besteht aus einer Reihenschaltung aus in Figur 1 nicht ausführlich dargestellten Submodulen und einer Induktivität, die in Figur 1 mit $L_{Kr}$ bezeichnet ist.

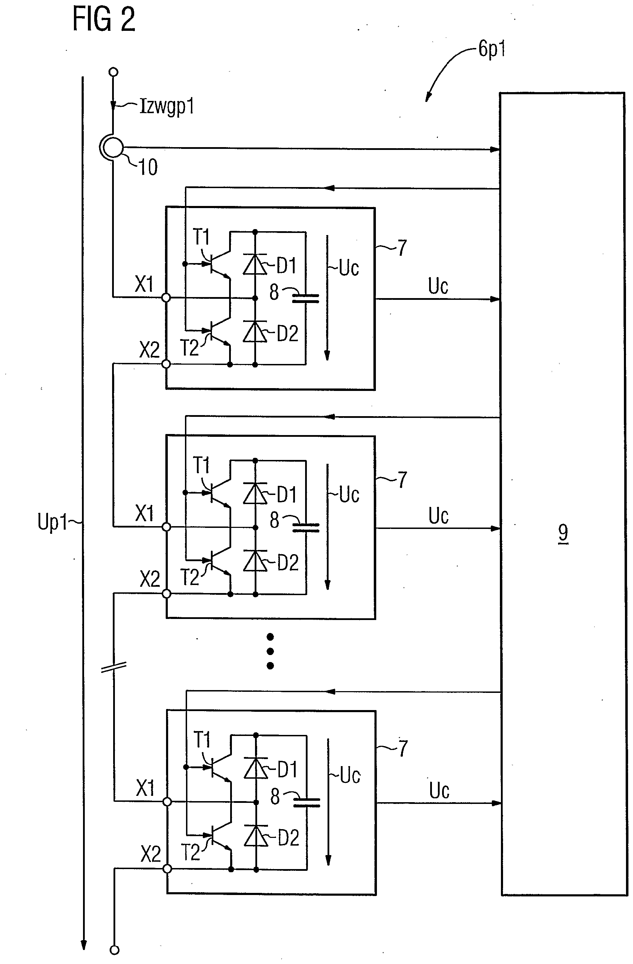

In Figur 2 ist die Reihenschaltung der Submodule 7 und insbesondere der Aufbau der Submodule durch ein elektrisches Ersatzschaltbild genauer dargestellt, wobei in Figur 2 lediglich der Phasenmodulzweig 6p1 herausgegriffen wurde. Die restlichen Phasenmodulzweige sind jedoch identisch aufgebaut. Es ist erkennbar, dass jedes Submodul 7 zwei in Reihe geschaltete abschaltbare Leistungshalbleiter T1 und T2 aufweist. Abschaltbare Leistungshalbleiter sind beispielsweise so genannte IGBTs, GTOs, IGCTs oder dergleichen. Diese sind dem Fachmann als solche bekannt, so dass eine ausführliche Darstellung an dieser Stelle entfallen kann. Jedem abschaltbaren Leistungshalbleiter T1, T2 ist eine Freilaufdiode D1, D2 antiparallel geschaltet. Parallel zur Reihenschaltung der abschaltbaren Leistungshalbleiter T1, T2 beziehungsweise der Freilaufdioden D1 und D2 ist ein Kondensator 8 als Energiespeicher geschaltet. Jeder Kondensator 8 ist unipolar aufgeladen. An den zweipoligen Anschlussklemmen X1 und X2 jedes Submoduls 7 können nunmehr zwei Spannungszustände erzeugt werden. Wird von einer Ansteuereinheit 9 beispielsweise ein Ansteuersignal erzeugt, mit dem der abschaltbare Leistungshalbleiter T2 in seine Durchgangsstellung überführt wird, in der ein Stromfluss über den Leistungshalbleiter T2 ermöglicht ist, fällt an den Klemmen X1, X2 des Submoduls 7 die Spannung null ab. Dabei befindet sich der abschaltbare Leistungshalbleiter T1 in seiner Sperrstellung, in der ein Stromfluss über den abschaltbaren Leistungshalbleiter T1 unterbrochen ist. Dies verhindert die Entladung des Kondensators 8. Wird hingegen der abschaltbare Leistungshalbleiter T1 in seine Durchgangsstellung, der abschaltbare Leistungshalbleiter T2 jedoch in seine Sperrstellung überführt, liegt an den Klemmen X1, X2 des Submoduls 7 die volle Kondensatorspannung Uc an.

Das Ausführungsbeispiel der erfindungsgemäßen Vorrichtung gemäß Figur 1 und 2 wird auch als so genannter Multi-Level-Stromrichter bezeichnet. Ein solcher Multi-Level-Stromrichter ist beispielsweise zum Antrieb elektrischer Maschinen, wie beispielsweise Motoren oder dergleichen, geeignet. Darüber hinaus eignet sich ein solcher Multilevelstromrichter auch für einen Einsatz im Bereich der Energieverteilung und -übertragung. So dient die erfindungsgemäße Vorrichtung beispielsweise als Kurzkupplung, die aus zwei gleichspannungsseitig miteinander verbundenen Stromrichtern besteht, wobei die Stromrichter jeweils mit einem Wechselspannungsnetz verbunden sind. Solche Kurzkupplungen werden zum Energieaustausch zwischen zwei Energieverteilungsnetzen eingesetzt, wobei die Energieverteilungsnetze beispielsweise eine unterschiedliche Frequenz, Phasenlage, Sternpunktbehandlung oder dergleichen aufweisen. Darüber hinaus kommen Anwendungen im Bereich der Blindleistungskompensation, als so genannte FACTS (Flexible AC Transmission Systems) in Betracht. Auch die Hochspannungsgleichstromübertragung über lange Strecken hinweg ist mit solchen Multilevelstromrichtern denkbar.

In Figur 2 ist ferner erkennbar, dass zum Messen der Zweigströme ein Zweigstromsensor 10 vorgesehen ist, der den über das Phasenmodul fließenden Strom unter Gewinnung von Phasenmodulzweigstromwerten erfasst, wobei die Zweigstromwerte über eine Glasfaserkommunikationsleitung zur Auswerteeinheit 9 hin übertragen werden. Ferner sind figürlich nicht dargestellte Submodulsensoren für jedes Submodul 7 vorgesehen, mit denen ein Spannungsabfall Uc an den Kondensatoren 8 unter Gewinnung von Kondensatorspannungswerten erfasst wird. Die Kondensatorspannungswerte werden ebenfalls an die Auswerteeinheit 9 übertragen, wobei gleichzeitig eine Information beigeschlossen wird, um welchen Kondensator es sich bei dem jeweiligen Messwert handelt. Die Auswerteeinheit ordnet den eingehenden Messwert einer Messzeit zu. Durch abschnittsweise Integration des Phasenmodulzweigstromes $I_{zwg}$ ergibt sich die Ladungsänderung $\Delta Q$ der Kondensatoren 8 des jeweiligen Phasenmoduls. Unter dem Begriff der abschnittsweisen Integration ist eine Integration in bestimmten Zeitintervallen zu verstehen. Es wird mit anderen Worten nur dann integriert, wenn die Schaltzustände der Leistungshalbleiter des jeweiligen Submoduls den Stromfluss zum Kondensator des Submoduls erlauben. Durch die Bestimmung einer Spannungsänderung, also die Änderung der an dem Kondensator 8 abfallenden Spannung bei einer bestimmten Zeitdauer, ergibt sich die Kapazität der Kondensatoren gemäß

$$C \approx \frac{\Delta Q}{\Delta UC}.$$

**Patentansprüche**

1. Vorrichtung (1) zum Umrichten eines elektrischen Stromes für eine Hochspannungsgleichstromübertragung mit wenigstens einem Phasenmodul (2a,2b,2c), das einen Wechselspannungsanschluss $(3_1,3_2,3_3)$ und wenigstens einen Gleichspannungsanschluss (p,n) aufweist, wobei zwischen jedem Gleichspannungsanschluss (p,n) und dem Wechselspannungsanschluss $(3_1,3_2,3_3)$ ein Phasenmodulzweig (6p1,6p2,6p3,6n1,6n2,6n3) ausgebildet ist und wobei jeder Phasenmodulzweig (6p1,6p2,6p3,6n1,6n2,6n3) über eine Reihenschaltung aus Submodulen (7) verfügt, die jeweils einen Kondensator (8) und wenigstens einen Leistungshalbleiter $(T_1,T_2)$ aufweisen, **gekennzeichnet durch** Kondensatordiagnosemittel zum zeitabhängigen Bestimmen der Kapazität jedes Kondensators (8), wobei

die Kondensatordiagnosemittel für jedes Phasenmodul (2a,2b,2c) einen Zweigstromsensor (10) zum Erfassen eines in dem zugeordneten Phasenmodul (2a,2b,2c) fließenden Phasenmodulzweigstromes (Izwg) und für jedes Submodul (7) einen Submodulsensor zum Erfassen einer an dem Kondensator (8) des zugeordneten Submoduls (7) abfallenden Kondensatorspannung (Uc) sowie Mittel zum Erfassen der Schaltzustände des oder der Leistungshalbleiter des jeweils zugeordneten Submoduls aufweisen, wobei eine Auswerteeinheit (9) die Kapazität der Kondensatoren (8) jedes Phasenmoduls (2a,2b,2c) in Abhängigkeit des jeweils gemessenen Phasenmodulzweigstromes (Izwg), der Schaltzustände des oder der Leistungshalbleiter und der jeweiligen Kondensatorspannung (Uc) bestimmt, wobei die Auswerteeinheit den Phasenmodulzweigstrom (Izwg) zum Erhalten einer Ladungsänderung (ΔQ) zwischen dem Zu- und Abschalten der Leistungshalbleiter der Submodule abschnittsweise nur dann integriert, wenn die Schaltzustände der Leistungshalbleiter des jeweiligen Submoduls den Stromfluss zum Kondensator des Submoduls erlauben.

2. Verfahren zum Umrichten eines Stromes mittels eines Umrichters (1) für eine Hochspannungsgleichstromübertragung, der wenigstens ein Phasenmodul (2a,2b,2c) mit wenigstens einem Gleichspannungsanschluss (p,n) und einem Wechselspannungsanschluss $(3_1,3_2,3_3)$ aufweist, wobei zwischen jedem Gleichspannungsanschluss (p,n) und dem Wechselspannungsanschluss $(3_1,3_2,3_3)$ ein Phasenmodulzweig (6p1,6p2,6p3,6n1,6n2,6n3) ausgebildet ist, der über eine Reihenschaltung aus Sub

modulen (7) verfügt, die jeweils einen Kondensator (8) und wenigstens einen Leistungshalbleiter $(T_1,T_2)$ aufweisen, bei dem die Kapazität jedes Kondensators in Abhängigkeit der Zeit bestimmt wird, indem der Phasenmodulzweigstrom (Izwg) eines jeden Phasenmoduls (2a,2b,2c) unter Gewinnung von Zweigstromwerten erfasst und die an jedem Kondensator (8) abfallende Kondensatorspannung (Uc) unter Gewinnung von Kondensatorspannungswerten gemessen und schließlich eine Spannungsänderung (ΔUc) ermittelt wird, der Phasenmodulzweigstrom (Izwg) zum Erhalten der Ladungsänderung (ΔQ) zwischen dem Zu- und Abschalten der Leistungshalbleiter der Submodule abschnittsweise integriert und die Änderung der Kapazität (ΔC) der Kondensatoren (8) des jeweiligen Phasenmoduls (2a,2b,2c) aus der Ladungsänderung (ΔQ) und aus der Spannungsänderung (ΔUc) bestimmt wird, wobei der Phasenmodulzweigstrom (Izwg) nur dann integriert wird, wenn die Schaltzustände der Leistungshalbleiter des jeweiligen Submoduls den Stromfluss zum Kondensator des Submoduls erlauben.

**Claims**

1. Device (1) for converting an electrical current for a high-voltage direct current transmission with at least one phase module (2a, 2b, 2c), which has an AC voltage connection $(3_1, 3_2, 3_3)$ and at least one DC voltage connection (p,n), a phase module branch (6p1, 6p2, 6p3, 6n1, 6n2, 6n3) being formed between each DC voltage connection (p,n) and the AC voltage connection $(3_1, 3_2, 3_3)$, and each phase module branch (6p1, 6p2, 6p3, 6n1, 6n2, 6n3) having a series circuit comprising submodules (7), which each have a capacitor (8) and at least one power semiconductor $(T_1, T_2)$, **characterized by** capacitor diagnosis means for the time-dependent determination of the capacitance of each capacitor (8), the capacitor diagnosis means having for each phase module (2a, 2b, 2c) a branch current sensor (10) for detecting a phase module branch current (Izwg) flowing in the assigned phase module (2a, 2b, 2c), and for each submodule (7) a submodule sensor for detecting a capacitor voltage (Uc) dropped across the capacitor (8) of the assigned submodule (7) and also means for detecting the switching states of the power semiconductor or power semiconductors of the respectively assigned submodule, an evaluation unit (9) determining the capacitance of the capacitors (8) of each phase module (2a, 2b, 2c) in a manner dependent on the respectively measured phase module branch current (Izwg), the switching states of the power semiconductor or power semiconductors and the respective capacitor voltage (Uc), the evaluation unit integrating the phase module branch current (Izwg) in sections for obtaining a charge change ($\Delta$Q) between the turn-on and turn-off of the power semiconductors of the submodules only if the switching states of the power semiconductors of the respective submodule permit the current flow to the capacitor of the submodule.

2. Method for converting a current by means of a converter (1) for a high-voltage direct current transmission having at least one phase module (2a, 2b, 2c) having at least one DC voltage connection (p, n) and an AC voltage connection ($3_1$, $3_2$, $3_3$), a phase module branch (6p1, 6p2, 6p3, 6n1, 6n2, 6n3) being formed between each DC voltage connection (p, n) and the AC voltage connection ($3_1$, $3_2$, $3_3$), said phase module branch having a series circuit comprising submodules (7), which each have a capacitor (8) and at least one power semiconductor ($T_1$, $T_2$), in which the capacitance of each capacitor is determined in a manner dependent on time, by the phase module branch current (Izwg) of each phase module (2a, 2b, 2c) being detected whilst obtaining branch current values and the capacitor voltage (Uc) dropped across each capacitor (8) being measured whilst obtaining capacitor voltage values and, finally, a voltage change ($\Delta$Uc) being determined, the phase module branch current (Izwg), for obtaining the charge change ($\Delta$Q) between the turn-on and turn-off of the power semiconductors of the submodules, being integrated in sections and the change in the capacitance ($\Delta$C) of the capacitors (8) of the respective phase module (2a, 2b, 2c) being determined from the charge change ($\Delta$Q) and from the voltage change ($\Delta$Uc), the phase module branch current (Izwg) being integrated only if the switching states of the power semiconductors of the respective submodule permit the current flow to the capacitor of the submodule.

**Revendications**

1. Dispositif (1) de transformation d'un courant électrique pour un transport de courant continu en haute tension, comprenant au moins un module (2a, 2b, 2c) de phase, qui a une borne ($3_1$, $3_2$, $3_3$) de tension alternative et au moins une borne (p, n) de tension continue, dans lequel une branche (6p1, 6p2, 6p3, 6n1, 6n2, 6n3) de module de phase est constituée entre chaque borne (p, n) de tension continue et la borne ($3_1$, $3_2$, $3_3$) de tension alternative et dans lequel chaque branche (6p1, 6p2, 6p3, 6n1, 6n2, 6n3) de module de phase dispose d'un montage série composé de sous-modules (7), qui ont chacun un condensateur (8) et au moins un semi-conducteur ($T_1$, $T_2$) de puissance, **caractérisé par**

des moyens de diagnostic de condensateur pour la détermination en fonction du temps de la capacité de chaque condensateur (8), les moyens de diagnostic de condensateur ayant, pour chaque module (2a, 2b, 2c) de phase, un capteur (10) de courant de branche afin de détecter un courant (Izwg) de branche de module de phase passant dans le module (2a, 2b, 2c) de phase associé et, pour chaque sous-module (7), un capteur de sous-module afin de détecter une tension (Uc) de condensateur chutant aux bornes du condensateur (8) du sous-module (7) associé, ainsi que des moyens de détection des états de commutation du ou des semi-conducteurs de puissance du sous-module respectivement associé, une unité (9) d'exploitation, qui détermine la capacité des condensateurs de chaque module (2a, 2b, 2c) de phase en fonction du courant ($I_{zwg}$) de branche de module de phase mesuré respectivement, des états du commutation du ou des semi-conducteurs de puissance et de la tension (Uc) respective de condensateur, l'unité d'exploitation n'intégrant par segment le courant (Izwg) de branche de module de phase, pour obtenir une variation ($\Delta$Q) de charge entre la mise à l'état passant et la mise à l'état bloqué des semi-conducteurs de puissance des sous-modules, que si les états de commutation des semi-conducteurs de puissance du sous-module respectif permettent le flux de courant vers le condensateur du sous-module.

2. Procédé de transformation d'un courant au moyen d'un transformateur (1) pour un transport de courant continu en haute tension, qui a au moins un module (2a, 2b, 2c) de phase ayant au moins une borne (p, n) de tension continue et une borne ($3_1$, $3_2$, $3_3$) de tension alternative, une branche (6p1, 6p2, 6p3, 6n1, 6n2, 6n3) de module de phase étant constituée entre chaque borne (p, n) de tension continue et la borne ($3_1$, $3_2$, $3_3$) de tension alternative, branque qui dispose d'un montage série composé de sous-modules (7), qui ont chacun un condensateur (8) et au moins un semi-conducteur ($T_1$, $T_2$) de puissance, dans lequel on détermine la capacité de chaque condensateur en fonction du temps, en détectant le courant ($I_{zwg}$) de branche de module de phase de chaque module (2a, 2b, 2c) de phase, en obtenant des valeurs de courant de branche, et en mesurant la tension (Uc) chutant aux bornes de chaque condensateur (8), en obtenant des valeurs de tension de condensateur et enfin en déterminant une variation ($\Delta$Uc) de tension, dans lequel on n'intègre par segment le courant (Izwg) de branche de module de phase, pour obtenir la variation ($\Delta$Q) de charge entre la mise à l'état passant et à l'état bloqué des semi-conducteurs de puissance des sous-module, et on détermine la variation de la capacité ($\Delta$Q) des condensateurs (8) du module (2a, 2b, 2c) de phase respectif à partir de la variation de charge ($\Delta$Q) et de la

variation de tension (ΔUc), dans lequel on n'intègre le courant (Izwg) du module de phase que si les états de commutation des semi-conducteurs de puissance du sous-module respective autorisent le flux de courant vers le condensateur du sous-module.

FIG 1

EP 2 100 365 B1

EP 2 100 365 B1

## FIG 2

9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005045090
- DE 10103031 A1
- DE 10309937 A1

**In der Beschreibung aufgeführte Nicht-Patentliteratur**

- **A. LESNICAR ; R. MARQUARDT.** An Innovative Modular Multilevel Converter Topology Suitable for a Wide Power Range. Powertech, 2003
- **R. MARQUARDT ; A. LESNICAR ; J. HILDINGER.** Modulares Stromrichterkonzept für Netzkupplungsanwendung bei hohen Spannungen. *ETG-Fachtagung in Bad Nauenheim,* 2002
- **A. LESNICAR ; R. MARQUARDT.** A new modular voltage source inverter topology. EPE, 2003
- **R. MARQUARDT ; A. LESNICAR.** New Concept for High Voltage - Modular Multilevel Converter. *PESC 2004 Conference in Aachen*